# EUROPÄISCHE PATENTSCHRIFT

(11) **EP 3 803 280 B1**
(45) Veröffentlichungstag und Bekanntmachung des Hinweises auf die Patenterteilung: **25.05.2022**
(21) Anmeldenummer: 19725937.7
(22) Anmeldetag: 10.05.2019
(51) Int. Cl.: G01D 21/00, G01D 7/00, G01D 7/04

(54) **FELDGERÄT DER MESS- UND AUTOMATISIERUNGSTECHNIK**
METROLOGY AND AUTOMATION FIELD DEVICE
APPAREIL DE TERRAIN UTILISÉ EN TECHNIQUE DE MESURE ET D'AUTOMATION

(30) Priorität: 08.06.2018 DE 102018113723
(43) Veröffentlichungstag der Anmeldung: 14.04.2021
(73) Patentinhaber: Endress + Hauser Flowtec AG, 4153 Reinach (CH)
(72) Erfinder: TANNER, Lukas, 4104 Oberwil BL (CH); VITANESCU, Mihai, 5022 Rombach (CH); KRETZLER, Timo, 79589 Binzen (DE)
(74) Vertreter: Andres, Angelika Maria
(86) Internationale Anmeldenummer: PCT/EP2019/062091
(87) Internationale Veröffentlichungsnummer: WO 2019/233705

(56) Entgegenhaltungen:
- EP-A1- 2 960 631
- WO-A1-2014/082913
- DE-A1-102008 047 422
- DE-A1-102016 106 179
- DE-T5-112016 002 609

## Beschreibung

Die Erfindung betrifft ein Feldgerät der Mess- und Automatisierungstechnik, welches mit einer Anzeigeeinheit ausgestattet ist.

Die Anzeigeeinheit eines Feldgeräts wird üblicherweise dazu genutzt, Informationen zu Messgrößen oder zu einem Messprozess darzustellen, wie beispielsweise in der DE102016106179A1 offenbart.

Die EP2960631A1 beschreibt eine Anzeigevorrichtung eines Automobils mit Anzeigenadeln und einem Display. Die DE112016002609T5 zeigt eine weitere Anzeigevorrichtung eines Automobils mit einem Display. Die WO2014/082913A1 mit einem druckfesten Sichtfenstereinsatz, an welchem eine kapazitive Anzeigeeinrichtung angebracht ist. Die DE102008047422A1 zeigt ein Feldgerät mit einem Gehäuse, welches eine Anzeigeeinheit aufweist, wobei die Anzeigeeinheit ein Projektionsmodul und eine Projektionsfläche umfasst.

Je nach verwendeter Anzeigetechnologie benötigen solche Anzeigeeinheiten entweder eine geringe elektrische Leistung und sind auf eine rudimentäre Informationsdarstellung beschränkt, oder sie benötigen eine hohe elektrische Leistung und können Informationen auf vielfältige Art und Weise präsentieren. Im Bereich der Mess- und Automatisierungstechnik sind eine geringe elektrische Leistungsaufnahme und eine gute Informationsdarstellung sehr wichtig.

Aufgabe der Erfindung ist es daher, eine Anzeigeeinheit vorzuschlagen, bei welcher eine Anzeigeeinheit mit geringer elektrischer Leistungsaufnahme sowie mit guter Informationsdarstellung betreibbar ist.

Die Aufgabe wird gelöst durch ein Feldgerät gemäß dem unabhängigen Anspruch 1.

Ein erfindungsgemäßes Feldgerät der Mess- und Automatisierungstechnik umfasst:
einen Messwandler, welcher dazu eingerichtet ist, mindestens eine Messgröße zu erfassen und jeweils zumindest einen die Messgröße repräsentierenden ersten Messwert auszugeben;
eine Anzeigeeinheit, welche dazu eingerichtet ist, Mess- und/oder Bedienparameter anzuzeigen;
eine elektronische Mess-/Betriebsschaltung, welche dazu eingerichtet ist, den Messwandler und/oder die Anzeigeeinheit zu betreiben, sowie aus dem ersten Messwert einen abgeleiteten zweiten Messwert zu berechnen;
wobei die Anzeigeeinheit eine Bildfläche aufweist,
wobei
   die Bildfläche einen ersten Bereich mit einer ersten Anzeigetechnologie und einen zweiten Bereich mit einer zweiten Anzeigetechnologie aufweist,
   wobei der erste Bereich reflektiv oder transreflektiv ausgestaltet ist, und wobei der zweite Bereich transmissiv ausgestaltet ist.

In einer Ausgestaltung ist der erste Bereich dazu eingerichtet, dauerhaft betrieben zu werden, wobei der zweite Bereich dazu eingerichtet ist, bei Bedarf oder ereignisgesteuert aktiviert zu werden.

Auf diese Weise kann ein leistungsaufnahmearmes Darstellen von Informationen falls nötig mit einer guten, beispielsweise farbigen und/oder hochaufgelösten Informationsdarstellung verknüpft werden.

In einer Ausgestaltung ist der erste Bereich zumindest ausschnittsweise berührempfindlich oder eine Berührempfindlichkeit des ersten Bereichs zumindest ausschnittsweise aktivierbar.

In einer Ausgestaltung weist das Feldgerät einen Energiespeicher auf, welcher dazu eingerichtet ist, das Feldgerät mit Energie zu versorgen, wobei das Feldgerät einen Energieversorgungsanschluss aufweist, mittels welchem eine externe Energieversorgung anschließbar ist,
wobei der zweite Bereich dazu eingerichtet ist, bei Anschluss einer externen Energieversorgung aktiviert zu werden.

In einer Ausgestaltung ist der zweite Bereich dazu eingerichtet, zumindest ein Element der folgenden Liste anzuzeigen:
mindestens einen Messwert,
mindestens einen Betriebsparameter,
mindestens einen zeitlichen Verlauf mindestens eines Messwerts und/oder mindestens eines Betriebsparameters,
einen aufgearbeiteten zeitlichen Verlauf des vorigen Elements,
ein Auswahlmenü zum Auswählen von darzustellenden Informationen.

Die Liste ist beispielhaft und nicht einschränkend bzw. erschöpfend auszulegen.

In einer Ausgestaltung weist der erste Bereich zumindest zwei Betriebsmodi auf, wobei der erste Bereich dazu eingerichtet ist, bei nicht aktiviertem zweiten Bereich in einem ersten Betriebsmodus zu arbeiten, sowie bei aktiviertem zweiten Bereich in einem zweiten Betriebsmodus zu arbeiten.

Auf diese Weise kann das Verhalten des ersten Bereichs an die Aktivität des zweiten Bereichs angepasst werden.

In einer Ausgestaltung umfasst der erste Betriebsmodus ein Anzeigen von mindestens einem Betriebsparameter und/oder von mindestens einem Messwert, wobei der zweite Betriebsmodus eine Einrichtung von mindestens einem berührungsempfindlichen Ausschnitt umfasst.

Zusätzlich kann im ersten Betriebsmodus auch mindestens ein berührungsempfindlicher Abschnitt eingerichtet werden, um zwischen verschiedenen anzuzeigenden Informationen wie beispielsweise Messwerten zu wechseln.

In einer Ausgestaltung umfasst der zweite Betriebsmodus eine Einrichtung einer Mehrzahl von berührungsempfindlichen Ausschnitten, wobei mindestens ein Ausschnitt eine Bedientaste oder eine Sprungfunktion oder eine Bildlaufleiste darstellt oder Teil einer Bildlaufleiste ist.

Die mindestens eine Bedientaste kann beispielsweise zum Navigieren durch ein im zweiten Bereich dargestelltes Bedien- oder Auswahlmenü eingerichtet sein. Eine Sprungfunktion ist beispielsweise dazu eingerichtet, direkt zu einer häufig benötigten Informationsanzeige zu wechseln.

In einer Ausgestaltung ist die erste Anzeigetechnologie eine Einfarbenanzeigetechnologie und basiert beispielsweise auf einer Flüssigkristalltechnologie. Auf diese Weise lässt sich ein energiesparender Betrieb der Anzeige im ersten Betriebsmodus sicherstellen.

In einer Ausgestaltung ist die zweite Anzeigetechnologie eine Mehrfarbenanzeigetechnologie, wobei die zweite Anzeigetechnologie beispielsweise auf einem der folgenden Prinzipien basiert:
TFT, OLED.

Auf diese Weise kann beispielsweise im Falle einer externen Energieversorgung eine gute Informationsdarstellung gewählt werden.

In einer Ausgestaltung ist der zweite Bereich zumindest ausschnittsweise berührempfindlich oder eine Berührempfindlichkeit des zweiten Bereichs zumindest ausschnittsweise aktivierbar.

In einer Ausgestaltung weist der erste Bereich eine Leistungsaufnahme von weniger als 10 mW und bevorzugt weniger als 3 mW und insbesondere weniger als 1 mW auf, und/oder wobei der zweite Bereich eine Leistungsaufnahme von weniger als 1000 mW und bevorzugt weniger als 500 mW und insbesondere weniger als 300 mW aufweist.

In einer Ausgestaltung weist der erste Bereich in einer Breite und/oder in einer Höhe mindestens 50 Pixel und bevorzugt mindestens 100 Pixel und bevorzugt mindestens 200 Pixel auf,
und wobei der zweite Bereich in einer Breite und/oder in einer Höhe mindestens 150 Pixel und bevorzugt mindestens 250 Pixel und bevorzugt mindestens 350 Pixel aufweist.

In einer Ausgestaltung weist die Bildfläche in einer Breite und/oder Höhe eine Ausdehnung von höchstens 12 cm und insbesondere höchstens 8 cm und bevorzugt höchstens 6 cm auf.

In einer Ausgestaltung ist das Feldgerät ein Feldgerät der Durchflussmesstechnik und weist zumindest ein Messrohr zum Führen eines Mediums auf.

In einer Ausgestaltung ist das Feldgerät ein magnetisch-induktives Durchflussmessgerät, wobei der Messwandler Folgendes aufweist:
ein Magnetsystem zum Erzeugen eines senkrecht zu einer Messrohrachse verlaufenden Magnetfelds,
zumindest ein Paar Messelektroden zum Abgreifen einer im Medium induzierten, durchflussabhängigen Spannung.

Insbesondere bei magnetisch-induktiven Durchflussmessgeräten, bei welchen das Magnetsystem bereits einen erhöhten Leistungsbedarf aufweist, ist eine erfindungsgemäße Anzeigeeinheit von Vorteil, da somit der Energiespeicher weniger stark belastet wird und die Lebensdauer des magnetisch-induktiven Durchflussmessgeräts verlängert werden kann.

Im Folgenden wird die Erfindung anhand von Ausführungsbeispielen beschrieben.

Fig. 1 skizziert eine beispielhafte erfindungsgemäße Anzeigeeinheit eines erfindungsgemäßen Feldgeräts in einem ersten Betriebsmodus.

Fig. 2 skizziert die beispielhafte Anzeigeeinheit in einem zweiten Betriebsmodus.

Fig. 3 skizziert ein beispielhaftes erfindungsgemäßes Feldgerät.

Fig. 4 skizziert ein beispielhaftes erfindungsgemäßes Feldgerät.

Fig. 5 skizziert ein beispielhaftes erfindungsgemäßes Feldgerät.

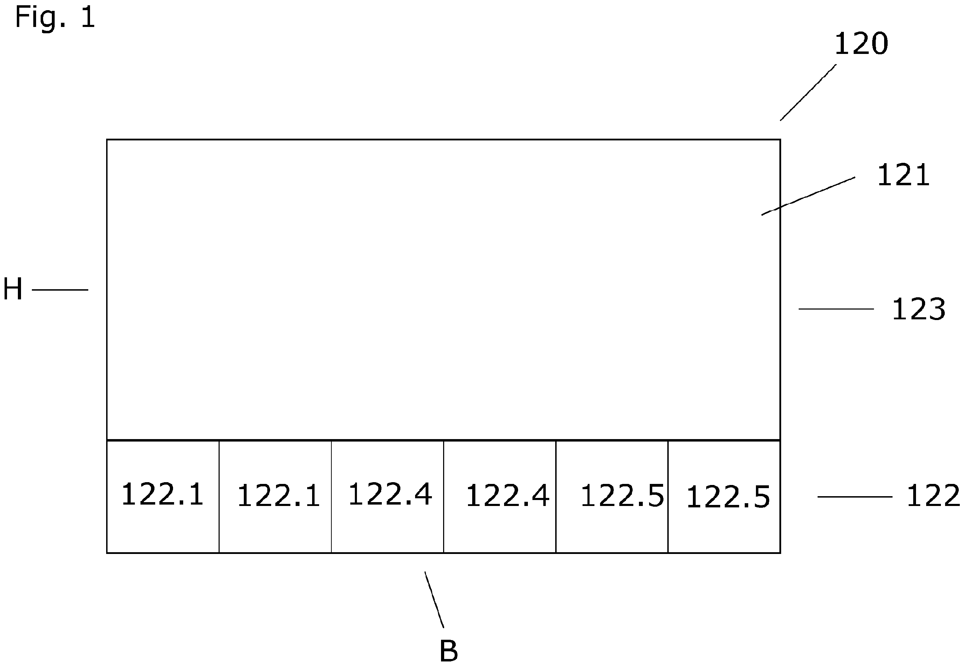

Fig. 1 skizziert eine beispielhafte erfindungsgemäße Anzeigeeinheit 120 in einem ersten Betriebsmodus, wobei die Anzeigeeinheit eine Bildfläche 121 mit einem ersten Bereich 122 und einem zweiten Bereich 123 aufweist. Der erste Bereich 122 basiert dabei auf einer ersten energiesparenden Anzeigetechnologie wie beispielsweise einer Flüssigkristalltechnologie, und der zweite Bereich 123 basiert auf einer zweiten Anzeigetechnologie, welche einen höheren Leistungsbedarf aufweist und beispielsweise mehrfarbige und/oder hochaufgelöste Inhalte darstellen kann. Der zweite Bereich ist im ersten Betriebsmodus der Anzeigeeinheit abgeschaltet, und in einem zweiten Betriebsmodus angeschaltet, wobei das Anschalten des zweiten Bereichs nach Bedarf oder ereignisgesteuert eingerichtet werden kann. So kann der zweite Bereich beispielsweise bei Anschließen einer externen Energieversorgung an das Feldgerät angeschaltet werden.

Im ersten Betriebsmodus kann der erste Bereich beispielsweise dazu eingerichtet sein, wie gezeigt Bedientasten 122.1, Messwerte 122.4 und Betriebsparameter 122.5 anzuzeigen, wobei zumindest im Bereich der Bedientasten eine Berührempfindlichkeit eingerichtet ist. Die gezeigte Ausgestaltung ist rein beispielhaft und nicht beschränkend auszulegen.

Die Bildfläche 123 weist eine Breite B und/oder Höhe H von höchstens 12 cm und insbesondere höchstens 8 cm auf, damit die Anzeigeeinheit kompakt ausgestaltet werden kann.

Der erste Bereich 122 in einer ersten Breite und/oder in einer ersten Höhe mindestens 50 Pixel und bevorzugt mindestens 100 Pixel und bevorzugt mindestens 200 Pixel aufweist, und wobei der zweite Bereich in einer zweiten Breite und/oder in einer zweiten Höhe mindestens 150 Pixel und bevorzugt mindestens 250 Pixel und bevorzugt mindestens 350 Pixel aufweist. Somit kann mittels der höheren Pixelzahl des zweiten Bereichs Information detailliert dargestellt werden.

Die geometrische Ausgestaltung des Bildbereichs sowie des ersten Bereichs und des zweiten Bereichs wie in Fig. 1 gezeigt ist beispielhaft und nicht beschränkend auszulegen.

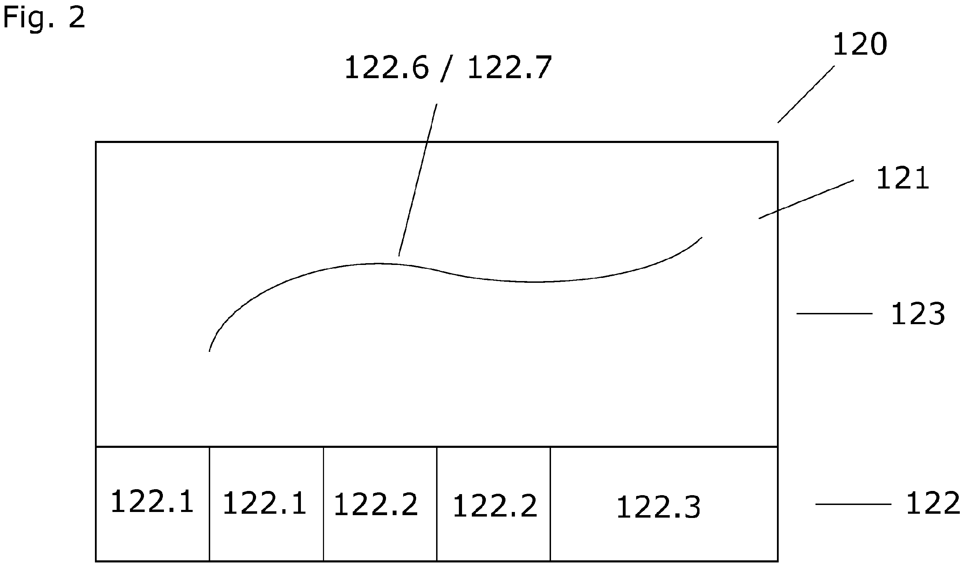

Fig. 2 skizziert die Anzeigeeinheit im zweiten Betriebsmodus mit angeschaltetem zweiten Bereich 123, in welchem zweiten Bereich ein Verlauf 122.6 bzw. ein aufgewerteter Verlauf 122.7 einer Messgröße oder eines Betriebsmodus dargestellt ist. Ein Aufwerten eines Verlaufs kann beispielsweise ein Glätten oder Filtern oder eine allgemeine Signalbearbeitung umfassen. Anstatt eines Verlaufs kann auch anderes wie beispielsweise Bedieninstruktionen, einstellbare Parameter, mindestens eine Menüstruktur, mindestens ein Diagramm wie beispielsweise ein Säulendiagramm dargestellt werden. Solche Diagramme sind beispielsweise Grenzwerte oder historische Minimal- oder Maximalwerte von beispielsweise Messwerten. Der Fachmann ist hierbei nicht durch diese Aufzählung beschränkt.

Im zweiten Betriebsmodus kann beispielsweise wie gezeigt der erste Bereich eine andere Aufteilung als im ersten Betriebsmodus aufweisen. Beispielsweise kann der erste Bereich nun Bedientasten 122.1, Sprungfunktionen 122.2 und mindestens eine Bildlaufleiste 122.3 aufweisen. Auch in diesem Fall ist die gezeigte Aufteilung des ersten Bereichs beispielhaft.

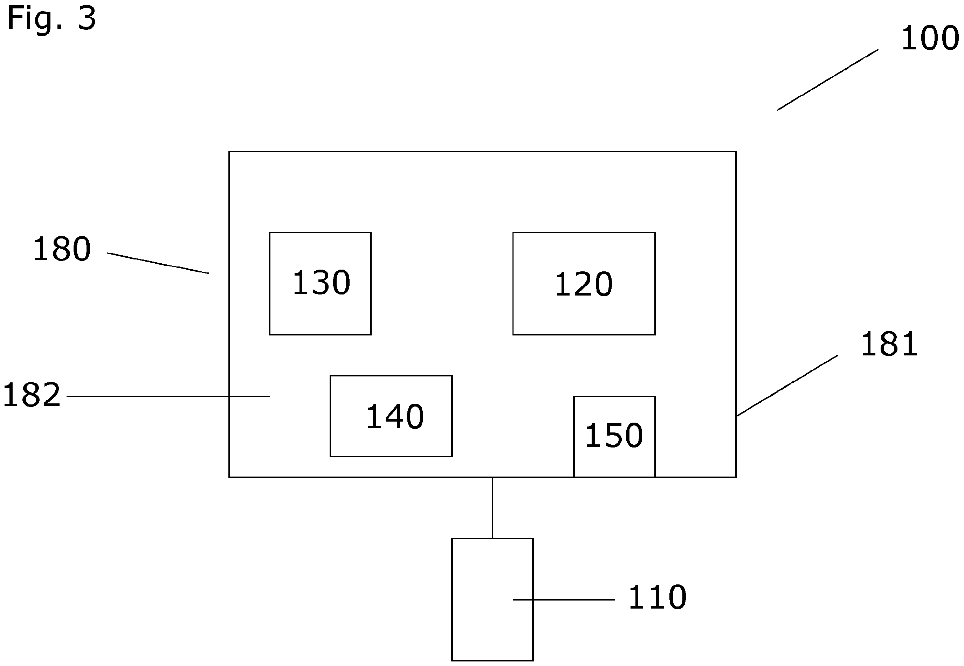

Fig. 3 skizziert ein beispielhaftes allgemeines erfindungsgemäßes Feldgerät 100 mit einem Gehäuse 180 mit einer Gehäusewandung 181, welche Gehäusewandung eine Gehäusekammer 182 umschließt. Das Feldgerät weist einen Messwandler 110 auf, mittels welchem eine Messgröße erfassbar und jeweils zumindest einen die Messgröße repräsentierenden ersten Messwert ausgebbar ist. Ein solcher Messwandler kann beispielsweise mindestens einen Ultraschallwandler, mindestens ein Thermometer oder andere auf anderen physikalischen basierende Sensoren umfassen. Das Feldgerät weist des Weiteren einen Energiespeicher 140 zur Energieversorgung, einen Energieversorgungsanschluss 150 zum Anschließen einer externen Energiequelle und eine elektronische Mess-/Betriebsschaltung 130 zum Betreiben des Feldgeräts auf. Die Anzeigeeinheit 120 kann wie in Fig. 3 skizziert in der Gehäusewandung eingelassen sein. Alternativ kann die Anzeigeeinheit auch auf einer Außenseite der Gehäusewandung befestigt werden oder vom Gehäuse beabstandet sein. Eine Kommunikation zwischen Anzeigeeinheit und elektronischer Betriebsschaltung 130 kann mittels einer elektrischen Verbindung oder per Funk stattfinden. Die elektronische Mess-/Betriebsschaltung 130 ist mittels elektrischer Verbindungen mit dem Messwandler 110, dem Energiespeicher 140 sowie dem Energieversorgungsanschluss 150 verbunden.

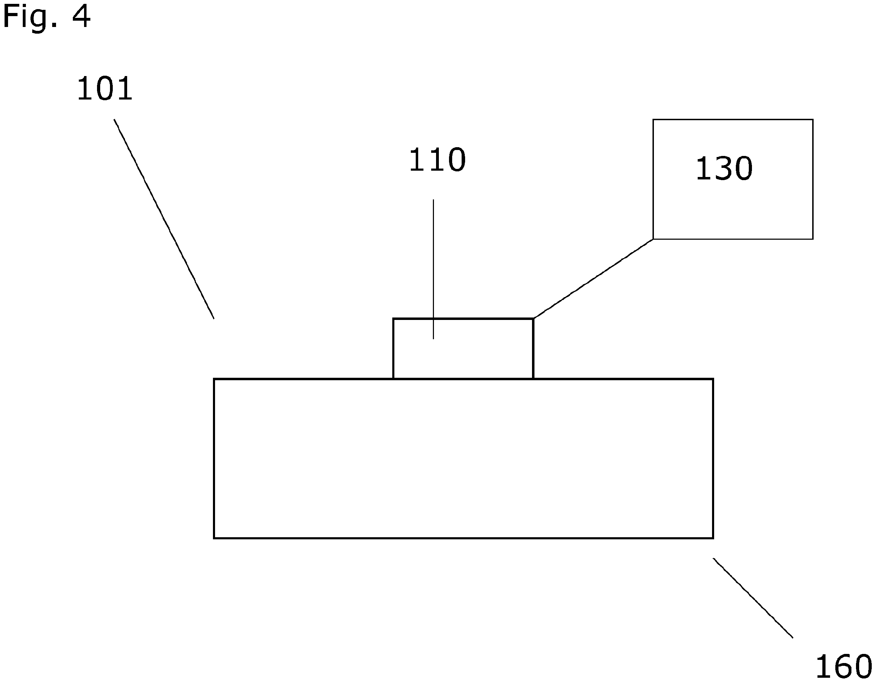

Fig. 4 skizziert ein Durchflussmessgerät zum Messen eines Massedurchflusses oder einer Durchflussgeschwindigkeit eines durch ein Messrohr strömendem Mediums mit einem Messrohr 160, einem am Messrohr angeordneten Messwandler 110, und einer elektronischen Mess-/Betriebsschaltung 130. Weitere in Fig. 3 gezeigte Elemente sind der Übersichtlichkeit geschuldet nicht gezeigt. Je nach Messprinzip kann der Messwandler auch teilweise oder ganz im Messrohr angeordnet sein.

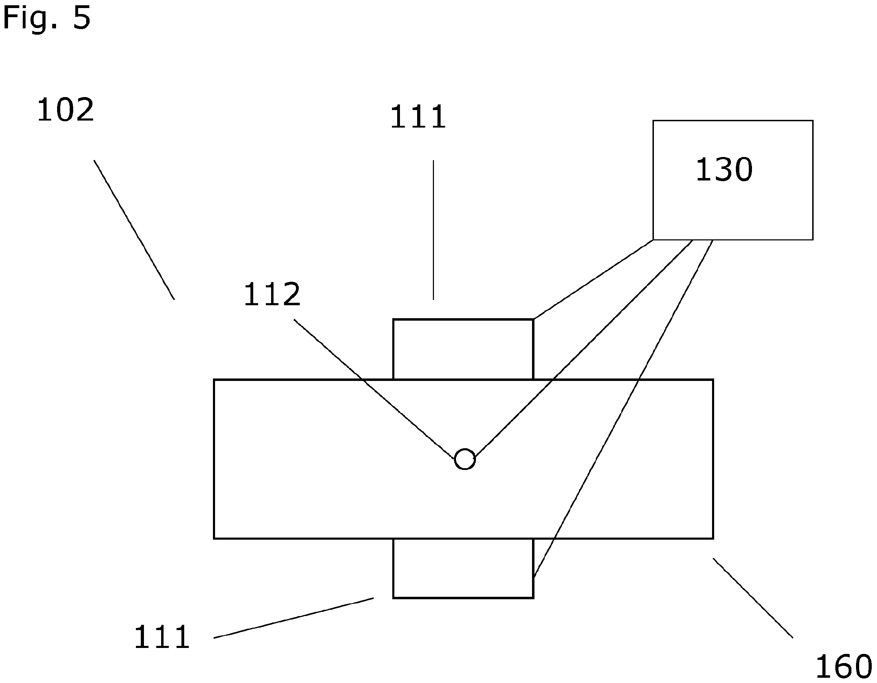

Fig. 5 skizziert ein magnetisch-induktives Durchflussmessgerät mit einem Messrohr 160, einem Messwandler umfassend ein Magnetsystem 111, ein Paar Messelektroden 112 (Der Perspektive der Skizze geschuldet ist nur eine Messelektrode gezeigt) und einer elektronischen Mess-/Betriebsschaltung 130. Weitere in Fig. 3 gezeigte Elemente sind der Übersichtlichkeit geschuldet nicht gezeigt. Das Magnetsystem ist dazu eingerichtet, ein senkrecht zu einer Messrohrachse verlaufendes Magnetfeld zu erzeugen. Mittels der Messelektroden 112 kann eine durchflussabhängige, durch das Magnetfeld und der Strömung des Mediums erzeugte elektrische Spannung abgegriffen und zum Erstellen von Durchflussmesswerten herangezogen werden.

### Bezugszeichenliste

- 100: Feldgerät
- 101: Durchflussmessgerät
- 102: magnetisch-induktives Durchflussmessgerät
- 110: Messwandler
- 111: Magnetsystem
- 112: Messelektrode
- 120: Anzeigeeinheit
- 121: Bildfläche
- 122: erster Bereich
- 122.1: Bedientaste
- 122.2: Sprungfunktion
- 122.3: Bildlaufleiste
- 122.4: Messwert
- 122.5: Betriebsparameter
- 122.6: zeitlicher Verlauf
- 122.7: aufgearbeiteter zeitlicher Verlauf
- 123: zweiter Bereich
- 130: elektronische Mess-/Betriebsschaltung
- 140: Energiespeicher
- 150: Energieversorgungsanschluss
- 160: Messrohr
- 180: Gehäuse
- 181: Gehäusewandung
- 182: Gehäusekammer
- B: Breite
- H: Höhe

## Patentansprüche

1. Feldgerät (100) der Mess- und Automatisierungstechnik umfassend:
einen Messwandler (110), welcher dazu eingerichtet ist, mindestens eine Messgröße zu erfassen und jeweils zumindest einen die Messgröße repräsentierenden ersten Messwert auszugeben;
eine Anzeigeeinheit (120), welche dazu eingerichtet ist, Mess- und/oder Bedienparameter anzuzeigen;
eine elektronische Mess-/Betriebsschaltung (130), welche dazu eingerichtet ist, den Messwandler und/oder die Anzeigeeinheit zu betreiben, sowie aus dem ersten Messwert einen abgeleiteten zweiten Messwert zu berechnen;
wobei das Feldgerät insbesondere ein Gehäuse (180) mit einer Gehäusewandung (181) und einer durch die Gehäusewandung ausgebildeten Gehäusekammer (182) aufweist, in welchem Gehäuse zumindest die Mess-/Betriebsschaltung angeordnet ist,
wobei die Anzeigeeinheit eine Bildfläche (121) aufweist,
**dadurch gekennzeichnet, dass**
die Bildfläche (121) einen ersten Bereich (122) mit einer ersten Anzeigetechnologie und einen zweiten Bereich (123) mit einer zweiten Anzeigetechnologie aufweist,
wobei der erste Bereich reflektiv oder transreflektiv ausgestaltet ist, und wobei der zweite Bereich transmissiv ausgestaltet ist.

2. Feldgerät nach Anspruch 1,
wobei der erste Bereich dazu eingerichtet ist, dauerhaft betrieben zu werden, und wobei der zweite Bereich dazu eingerichtet ist, bei Bedarf oder ereignisgesteuert aktiviert zu werden.

3. Feldgerät nach Anspruch 1 oder 2,
wobei der erste Bereich zumindest ausschnittsweise berührempfindlich ist oder eine Berührempfindlichkeit des ersten Bereichs zumindest ausschnittsweise aktivierbar ist.

4. Feldgerät nach einem der vorigen Ansprüche,
wobei das Feldgerät einen Energiespeicher (140) aufweist, welcher dazu eingerichtet ist, das Feldgerät mit Energie zu versorgen, und wobei das Feldgerät einen Energieversorgungsanschluss (150) aufweist, mittels welchem eine externe Energieversorgung anschließbar ist,
wobei der zweite Bereich dazu eingerichtet ist, bei Anschluss einer externen Energieversorgung aktiviert zu werden.

5. Feldgerät nach einem der vorigen Ansprüche,
wobei der zweite Bereich dazu eingerichtet ist, zumindest ein Element der folgenden Liste anzuzeigen:
mindestens einen Messwert (122.4),
mindestens einen Betriebsparameter (122.5),
mindestens einen zeitlichen Verlauf (122.6) mindestens eines Messwerts und/oder mindestens eines Betriebsparameters,
einen aufgearbeiteten zeitlichen Verlauf (122.7) des vorigen Elements.

6. Feldgerät nach einem der Ansprüche 3 bis 5,
wobei der erste Bereich zumindest zwei Betriebsmodi aufweist, wobei der erste Bereich dazu eingerichtet ist, bei nicht aktiviertem zweiten Bereich in einem ersten Betriebsmodus zu arbeiten, sowie bei aktiviertem zweiten Bereich in einem zweiten Betriebsmodus zu arbeiten.

7. Feldgerät nach Anspruch 6,
wobei der erste Betriebsmodus ein Anzeigen von mindestens einem Betriebsparameter und/oder von mindestens einem Messwert umfasst,
wobei der zweite Betriebsmodus eine Einrichtung von mindestens einem berührungsempfindlichen Ausschnitt umfasst.

8. Feldgerät nach Anspruch 7,
wobei der zweite Betriebsmodus eine Einrichtung einer Mehrzahl von berührungsempfindlichen Ausschnitten umfasst,
wobei mindestens ein Ausschnitt eine Bedientaste (122.1) oder eine Sprungfunktion (122.2) oder eine Bildlaufleiste (122.3) darstellt oder Teil einer Bildlaufleiste ist.

9. Feldgerät nach einem der vorigen Ansprüche,
wobei die erste Anzeigetechnologie eine Einfarbenanzeigetechnologie ist und beispielsweise auf einer Flüssigkeitskristalltechnologie basiert.

10. Feldgerät nach einem der vorigen Ansprüche,
wobei die zweite Anzeigetechnologie eine Mehrfarbenanzeigetechnologie ist, wobei die zweite Anzeigetechnologie auf einem der folgenden Prinzipien basiert:
TFT, OLED

11. Feldgerät nach einem der vorigen Ansprüche
wobei der zweite Bereich zumindest ausschnittsweise berührempfindlich ist oder eine Berührempfindlichkeit des zweiten Bereichs zumindest ausschnittsweise aktivierbar ist.

12. Feldgerät nach einem der vorigen Ansprüche,
wobei der erste Bereich eine Leistungsaufnahme von weniger als 10 mW und bevorzugt weniger als 3 mW und insbesondere weniger als 1 mW aufweist, und/oder wobei der zweite Bereich eine Leistungsaufnahme von weniger als 1000 mW und bevorzugt weniger als 500 mW und insbesondere weniger als 300 mW aufweist.

13. Feldgerät nach einem der vorigen Ansprüche,
wobei der erste Bereich in einer ersten Breite und/oder in einer ersten Höhe mindestens 50 Pixel und bevorzugt mindestens 100 Pixel und bevorzugt mindestens 200 Pixel aufweist,
und wobei der zweite Bereich in einer zweiten Breite und/oder in einer zweiten Höhe mindestens 150 Pixel und bevorzugt mindestens 250 Pixel und bevorzugt mindestens 350 Pixel aufweist.

14. Feldgerät nach einem der vorigen Ansprüche,
wobei die Bildfläche in einer Breite (b) und/oder Höhe (H) eine Ausdehnung von höchstens 12 cm und insbesondere höchstens 8 cm und bevorzugt höchstens 6 cm aufweist.

15. Feldgerät nach einem der vorigen Ansprüche,
wobei das Feldgerät ein Durchflussmessgerät (101) ist und zumindest ein Messrohr (160) zum Führen eines Mediums aufweist,
wobei das Feldgerät beispielsweise ein magnetisch-induktives Durchflussmessgerät (102) ist und folgendes gilt:
der Messwandler weist auf:
ein Magnetsystem (111) zum Erzeugen eines senkrecht zu einer Messrohrachse verlaufenden Magnetfelds,
zumindest ein Paar Messelektroden (112) zum Abgreifen einer im Medium durch das Magnetfeld induzierten, durchflussabhängigen Spannung.

## Claims

1. Field device (100) used in measuring and automation engineering, comprising:
a transducer (110), which is designed to measure at least a measured variable and to output at least a first measured value representing the measured variable;
a display unit (120), which is designed to display measuring and/or operating parameters;
an electronic measuring/operating circuit (130), which is designed to operate the transducer and/or the display unit, and to calculate a second measured value derived from the first measured value;
wherein the field device particularly has a housing (180) with a housing wall (181) and a housing chamber (182) formed by the housing wall, wherein at least the measuring/operating circuit is arranged in the housing,
wherein the display unit has a screen (121),
**characterized in that**
the screen (121) has a first zone (122) with a first display technology and a second zone (123) with a second display technology,
wherein the first zone is reflective or transflective, and wherein the second zone is transmissive.

2. Field device as claimed in Claim 1,
wherein the first zone is designed to be operated permanently and wherein the second zone is designed to be activated if required or on an event-controlled basis.

3. Field device as claimed in Claim 1 or 2,
wherein the first zone is at least partially touch-sensitive or a touch-sensitivity of the first zone can be activated at least in sections.

4. Field device as claimed in one of the previous claims,
wherein the field device comprises an energy storage unit (140) which is designed to supply energy to the field device, and wherein the field device has an energy supply connection (150) by means of which an external energy supply can be connected,
wherein the second zone is designed to be activated when an external energy supply is connected.

5. Field device as claimed in one of the previous claims,
wherein the second zone is designed to display at least one element of the following list:
at least one measured value (122.4),
at least one operating parameter (122.5),
at least one chronological sequence (122.6) of at least one measured value and/or of at least one operating parameter,
one processed chronological sequence (122.7) of the preceding element.

6. Field device as claimed in one of the Claims 3 to 5,
wherein the first zone has at least two operating modes, wherein the first zone is designed to function in a first operating mode when the second zone is not activated, and to function in a second operating mode when the second zone is activated.

7. Field device as claimed in Claim 6,
wherein the first operating mode comprises the displaying of at least one operating parameter and/or of at least one measured value,
wherein the second operating mode comprises the establishment of at least one touch-sensitive section.

8. Field device as claimed in Claim 7,
wherein the second operating mode comprises the establishment of multiple touch-sensitive sections,
wherein at least one section is an operating key (122.1) or a jump function (122.2) or a scrollbar (122.3) or is part of a scrollbar.

9. Field device as claimed in one of the previous claims,
wherein the first display technology is a single-color display technology and is based, for example, on a liquid crystal technology.

10. Field device as claimed in one of the previous claims,
wherein the second display technology is a multicolor display technology and is based on one of the following principles:
TFT, OLED.

11. Field device as claimed in one of the previous claims,
wherein the second zone is at least partially sensitive to touch or a touch-sensitivity of the second zone can be activated at least in sections.

12. Field device as claimed in one of the previous claims,
wherein the first zone has a power consumption of less than 10 mW and preferably of less than 3 mW and particularly of less than 1 mW, and/or wherein the second zone has a power consumption of less than 1,000 mW and preferably of less than 500 mW and particularly of less than 300 mW.

13. Field device as claimed in one of the previous claims,
wherein the first zone has, in a first width and/or in a first height, at least 50 pixels and particularly at least 100 pixels and preferably at least 200 pixels,
and wherein the second zone has, in a second width and/or in a second height, at least 150 pixels and particularly at least 250 pixels and preferably at least 350 pixels.

14. Field device as claimed in one of the previous claims,
wherein the screen has, in a width (b) and/or a height (H), an extension of a maximum of 12 cm and particularly of a maximum of 8 cm and preferably of a maximum of 6 cm.

15. Field device as claimed in one of the previous claims,
wherein the field device is a flowmeter (101) and has at least one measuring tube (160) designed to conduct a fluid,
wherein the field device is, for example, an electromagnetic flowmeter (102) and the following applies:
the transducer comprises:
a magnet system (111) designed to generate a magnetic field running perpendicularly to a measuring tube axis,
at least a pair of measuring electrodes (112) to measure a flow-dependent voltage induced in the medium by the magnetic field.

## Revendications

1. Appareil de terrain (100) de la technique de mesure et d'automatisation, comprenant :
un transducteur (110), lequel est conçu pour mesurer au moins une grandeur de mesure et pour émettre respectivement au moins une première valeur mesurée représentant la grandeur de mesure ;
une unité d'affichage (120), laquelle est conçue pour afficher des paramètres de mesure et/ou de commande ;
un circuit électronique de mesure/d'exploitation (130), lequel est conçu pour exploiter le transducteur et/ou l'unité d'affichage, ainsi que pour calculer une deuxième valeur mesurée dérivée de la première valeur mesurée ;
l'appareil de terrain présentant notamment un boîtier (180) avec une paroi de boîtier (181) et une chambre de boîtier (182) formée par la paroi de boîtier, boîtier dans lequel est disposé au moins le circuit de mesure/d'exploitation,
l'unité d'affichage présentant une surface d'image (121),
**caractérisé en ce que**
la surface d'image (121) présente une première zone (122) avec une première technologie d'affichage et une deuxième zone (123) avec une deuxième technologie d'affichage,
la première zone étant réfléchissante ou transréfléchissante, et la deuxième zone étant transmissive.

2. Appareil de terrain selon la revendication 1,
pour lequel la première zone est adaptée pour être actionnée en permanence et pour lequel la deuxième zone est adaptée pour être activée à la demande ou en fonction d'un événement.

3. Appareil de terrain selon la revendication 1 ou 2,
pour lequel la première zone est au moins partiellement sensible au toucher ou une sensibilité au toucher de la première zone peut être activée au moins partiellement.

4. Appareil de terrain selon l'une des revendications précédentes,
pour lequel l'appareil de terrain comprend un accumulateur d'énergie (140) qui est adapté pour alimenter l'appareil de terrain en énergie, et pour lequel l'appareil de terrain comprend une connexion d'alimentation en énergie (150) au moyen de laquelle une alimentation en énergie externe peut être raccordée,
pour lequel la deuxième zone est adaptée pour être activée lors du raccordement d'une alimentation en énergie externe.

5. Appareil de terrain selon l'une des revendications précédentes,
pour lequel la deuxième zone est adaptée pour afficher au moins un élément de la liste suivante :
au moins une valeur mesurée (122.4),
au moins un paramètre de fonctionnement (122.5),
au moins une courbe temporelle (122.6) d'au moins une valeur mesurée et/ou d'au moins un paramètre de fonctionnement,
une courbe temporelle traitée (122.7) de l'élément précédent.

6. Appareil de terrain selon l'une des revendications 3 à 5,
pour lequel la première zone comprend au moins deux modes de fonctionnement, la première zone étant adaptée pour fonctionner dans un premier mode de fonctionnement lorsque la deuxième zone n'est pas activée, et pour fonctionner dans un deuxième mode de fonctionnement lorsque la deuxième zone est activée.

7. Appareil de terrain selon la revendication 6,
pour lequel le premier mode de fonctionnement comprend un affichage d'au moins un paramètre de fonctionnement et/ou d'au moins une valeur mesurée,
pour lequel le deuxième mode de fonctionnement comprend une création d'au moins une partie d'image sensible au toucher.

8. Appareil de terrain selon la revendication 7,
pour lequel le deuxième mode de fonctionnement comprend la création d'une pluralité de parties d'image sensibles au toucher,
pour lequel au moins une partie d'image représente une touche de commande (122.1) ou une fonction de saut (122.2) ou une barre de défilement (122.3) ou faisant partie d'une barre de défilement.

9. Appareil de terrain selon l'une des revendications précédentes,
pour lequel la première technologie d'affichage est une technologie d'affichage monochrome et est basée, par exemple, sur une technologie à cristaux liquides.

10. Appareil de terrain selon l'une des revendications précédentes,
pour lequel la deuxième technologie d'affichage est une technologie d'affichage multicolore, la deuxième technologie d'affichage étant basée sur l'un des principes suivants :
TFT, OLED.

11. Appareil de terrain selon l'une des revendications précédentes,
pour lequel la deuxième zone est au moins partiellement sensible au toucher ou une sensibilité au toucher de la deuxième zone peut être activée au moins partiellement.

12. Appareil de terrain selon l'une des revendications précédentes,
pour lequel la première zone présente une consommation de puissance inférieure à 10 mW et de préférence inférieure à 3 mW et notamment inférieure à 1 mW, et/ou pour lequel la deuxième zone présente une consommation de puissance inférieure à 1 000 mW et de préférence inférieure à 500 mW et notamment inférieure à 300 mW.

13. Appareil de terrain selon l'une des revendications précédentes,
pour lequel la première zone présente dans une première largeur et/ou dans une première hauteur au moins 50 pixels et notamment au moins 100 pixels et de préférence au moins 200 pixels,
et pour lequel la deuxième zone présente dans une deuxième largeur et/ou dans une deuxième hauteur au moins 150 pixels et notamment au moins 250 pixels et de préférence au moins 350 pixels.

14. Appareil de terrain selon l'une des revendications précédentes,
pour lequel la surface d'image présente, dans une largeur (b) et/ou une hauteur (H), une extension d'au plus 12 cm et notamment d'au plus 8 cm et de préférence d'au plus 6 cm.

15. Appareil de terrain selon l'une des revendications précédentes,
l'appareil de terrain étant un débitmètre (101) et comprenant au moins un tube de mesure (160) destiné à guider un fluide,
l'appareil de terrain étant par exemple un débitmètre électromagnétique (102) et les définitions suivantes étant valables :
le transducteur comprenant :
un système magnétique (111) destiné à générer un champ magnétique s'étendant perpendiculairement à un axe de tube de mesure,
au moins une paire d'électrodes de mesure (112) pour prélever une tension dépendant du débit, induite dans le produit par le champ magnétique.
